# EUROPEAN PATENT SPECIFICATION

(11) **EP 1 626 438 B1**
(45) Date of publication and mention of the grant of the patent: **20.03.2013**
(21) Application number: 05107289.0
(22) Date of filing: 08.08.2005
(51) Int. Cl.: H01L 21/306, B81C 1/00

(54) **Anisotropic etching method for manufacturing micro-structures of silicon**
Anisotropes Ätzverfahren zur Herstellung von Siliziummikrostrukturen
Méthode de gravure anisotrope pour la production de microstructures en silicium

(30) Priority: 13.08.2004 JP 2004235871
(43) Date of publication of application: 15.02.2006
(73) Proprietor: MITSUBISHI GAS CHEMICAL COMPANY, INC., Chiyoda-ku, Tokyo 100-8324 (JP)
(72) Inventor: Yamada, Kenji c/o Mitsubishi Gas Chem. Co. Inc., Katushika-ku Tokyo (JP); Azuma, Tomoyuki, 5-2-2 Marunouchi Chiyoda-ku, Tokyo (JP)
(74) Representative: Gille Hrabal

(56) References cited:
- EP-A- 1 128 221
- WO-A-00/02238
- WO-A-98/10050
- WO-A-2006/050323
- WO-A1-03/064581
- FR-A1- 2 819 201
- JP-A- 9 246 234
- JP-A- 2003 101 056
- JP-A- 2004 087 724
- JP-A- 2004 119 674
- US-A- 5 597 678
- US-A- 5 795 702
- US-A- 5 804 090
- US-A1- 2001 001 785

## Description

### TECHNICAL FIELD

The present invention relates to etching technology for manufacturing of micro-structures of silicon used as Micro Electro Mechanical Systems (MEMS) parts, semiconductor materials, etc. More particularly, the present invention relates to a silicon anisotropic etching method.

### BACKGROUND ART

Conventionally, in the case where a silicon single-crystal substrate is etched with chemical agent solution, there are an etching method with the use of acid base etching agent which is a mixed aqueous solution having components of fluorinated acid, nitric acid, acetic acid, etc.; an etching method with the use of alkali base etching agent which is alkali base aqueous solution such as, for example, aqueous solution of potassium hydroxide, tetramethylammonium hydroxide, hydrazine, etc.; or so (refer to Sato, "Silicon etching technology", Surface Finishing, Vol. 51, No. 8, 2000, p754-759 and Esashi, "2003 Applied Micromachining / MEMS technology", p.109-114).

Among these, because the acid base etching agent has an isotropic etching rate without relation to crystal face orientation of a silicon single-crystal substrate, it was used for chemical polishing which uniformly etches the surface of a silicon wafer cut out from silicon single-crystal ingot. On the other hand, with regard to the alkali base etching agent, because it has an etching rate depending on crystal orientation of silicon single-crystal substrate, i.e., because the anisotropic etching is possible, it was used in micro electro mechanical work of silicon in combination with photolithographic technology.

During a manufacturing of micro-structures of silicon, because the acid base etching agent etches isotropicaly without relation to crystal face orientation, it will induce an enlargement of diameters of etching pits or an abnormal of pattern configuration caused by not only an intrinsic longitudinal etching but also an extravagant lateral etching, giving limitation on the application for structural working such as manufacturing of micro-structures of silicon. Further, because the acid base etching agent has a strong oxidizing ability which erodes silicon oxide used frequently as mask materials, a mask material which bears the corrosion becomes necessary when etching for pattern formation is conducted.

On the other hand, with regard to the alkali base etching agent, it has an etching rate depending on crystal orientation of silicon single-crystal substrate, i.e., anisotropic etching is possible, and at the same time, corrosion is little even for the silicon oxide film used as mask materials for pattern manufacture. Accordingly, it is frequently used in manufacture of MEMS parts or micro electro mechanical worked parts, and a selective etching method with a use of an etching agent adding alkaline aqueous solution and ethyl alcohol, phenol, etc., is proposed (refer to Japanese Unexamined Patent Application Laid-Open No. Hei 6-188236).

Research & investigation and analysis were carried out more and more about silicon etching with the use of alkali base etching agent. Etching agent currently employed most broadly is provided by adding alcohols such as isopropyl alcohol, ethyl alcohol, methyl alcohol into inorganic alkaline aqueous solution in order to control undercut or to smooth off a rugged structure in wall part configuration of etching pattern. Japanese Unexamined Patent Application Laid-Open No. Shou 49-076479 discloses a technology which controls generation of micro pyramids with the use of the alkali base etching agent prepared by combining 0.5 to 1 volume of anhydrous ethylenediamine to 1 volume of hydrazine hydrate while maintaining anisotropy of the silicon etching conventionally possessed by potassium hydroxide, sodium hydroxide and hydrazine. Japanese Unexamined Patent Application Laid-Open No. Hei 05-102124 discloses an idea of regulating an etching rate in treatment vessel uniform in an occasion of employing the etching agent consisting of alkaline aqueous solution and ethyl alcohol. Japanese Examined Patent Publication No. Hei 08-31452 discloses a silicon etching agent comprising alkali compound and higher alcohol that etches at the temperature lower than its flashing point highly selecting not p-type doped area but only other area. Japanese registered patent No. 3444009 discloses an alkali base etching agent having 3 components consisting of potassium hydroxide in an amount of 0.3 % or more, hydrazine and water. With the use of the alkali base etching agent, the etched surface becomes smooth, the etched bottom surface becomes parallel with the main surface and further, etching rate of silicon is so fast that might extremely little erode the silicon oxide film as a mask. US-A-5 804 090 discloses a method of anisotropically etching silicon using a composition comprising potassium hydroxide, hydrazine and water. Japanese registered patent No. 3525612 discloses a technology for getting smooth etching wall face by means of an etching agent prepared by combining 2 or more kinds of alkali compound different in the crystal face and with the maximum etching rate such as potassium hydroxide and ethylenediamine, potassium hydroxide and tetramethylammonium hydroxide, or potassium hydroxide and ammonia. Further, Japanese Unexamined Patent Application Laid-Open No. 2000-349063 discloses a technology that is capable of getting enhancement of etching rate and uniform etched surface by silicon etching wherein a reducing agent is added to a potassium hydroxide solution under an increased pressure.

Among the alkali base etching agent, an aqueous solution of metal hydroxide represented by potassium hydroxide relatively erodes the silicon oxide film in a large extent. Accordingly, in the case where a deep etching is conducted to a silicon single-crystal, it becomes necessary to form an extremely thick silicon oxide film or to employ a silicon nitride film as a masking material. Further, an aqueous solution of metal hydroxide such as potassium hydroxide, sodium hydroxide or so is insufficient in matching with a semiconductor process because it contains alkali metal ions having jeopardy of contaminating the semiconductor process.

On the other hand, the alkali base etching agent which is organic alkaline aqueous solution such as hydrazine aqueous solution, chlorine aqueous solution, tetramethylammonium hydroxide aqueous solution or so has a supreme property of almost not eroding the silicon oxide film and accordingly, a thin silicon oxide film might be employed even when a deep silicon etching is conducted. In particular, the tetramethylammonium hydroxide aqueous solution is broadly used for semiconductor process having favorable matching with semiconductor process because, in high purity case, as compared with other organic alkali compound, it does not contain alkali metal ions or other metal ions having jeopardy of contaminating the semiconductor process. Accordingly, the tetramethylammonium hydroxide aqueous solution is also frequently employed in manufacturing process of MEMS parts or manufacturing of micro-structures of silicon parts (refer to TABATA, "Silicon crystal anisotropy etching by TMAH aqueous solution", Surface Finishing, Vol.51, No. 8, 2000, p767-772).

The manufacturing of micro-structures of silicon combining photolithographic technology and anisotropic etching is popular also in MEMS field remarkably growing late years, and various alkali base etching agents are developed and employed. They are different in a ratio of etching rates depending on silicon crystal face (e.g., a ratio between an etching rate in face (111) and an etching rate in face (100)) or in a smoothness of an etching surface (i.e., bottom surface and wall surface).

On the other hand, aluminum or aluminum alloy is conventionally used in versatile as a material for electrodes or wirings in silicon semiconductor, etc. Because the aluminum or aluminum alloy is easily eroded by an alkaline aqueous solution, any countermeasure for protecting aluminum or aluminum alloy was essential in a case where an alkaline etchant is employed together with aluminum or aluminum alloy electrodes and wirings. Examples of the countermeasure include a method forming aluminum or aluminum alloy after using alkaline etchant, a method forming a protective layer having resistance against alkaline etchant over aluminum or aluminum alloy, a method changing materials for electrodes and wirings to metals having resistance in alkaline etchant instead of aluminum or aluminum alloy, and as proposed in Japanese Unexamined Patent Application Laid-Open Nos. 04-370932 and 2004-119674, a method decreasing an etching amount to aluminum or aluminum alloy by adding silicon or also oxidizing agent into the alkaline etchant.

However, processing time for silicon etching with the use of the alkali base etching agent becomes a key factor of determining the velocity for responding a demand of MEMS productivity improvement accompanied by market expand, and as a result, time reduction of the process became big problem. In other words, during silicon etching process in MEMS manufacture, there are many steps of performing etching silicon in depth of several hundred µm or greater, and although the etching rate varies to some extent depending on the composition of alkali base etching agent, a long process time of from ten and several hours to one day is required. The long process time causes problems that, in constructing mass production organization, it deviates from tolerance limit of the time allowable to spend for 1 step. For the purpose of overcoming the problems, some trials for shortening the process time of silicon etching by modifying composition of alkali base etching agent are carried out, however, from viewpoints of the difference of etching rate depending on crystal face, smoothness of etching surface (bottom surface or side surface) or chemical solution application restriction considering about safety, it is not easy to reconsider about versatile compositions of each company discovered upon the basis of application experience of many years and a lot of investigation or analysis. As a result, an improvement in productivity actually depends on spending long process time or on increasing etching equipment (vessel) without improving conventional composition.

Further, various countermeasures for troubles in employing alkaline etching agent with the use of electrodes and wiring materials of aluminum or aluminum alloy reveals the following problems: In the case where the countermeasure is performed by forming aluminum or aluminum alloy after etching silicon, or in the case where the countermeasure is performed by forming a protective layer having resistance against alkali etchant over aluminum or aluminum alloy, because structural strength of a separated portion from the silicon substrate by silicon etching is weak, both an application of photolithography or wet process etching for further etching after the film-forming of aluminum or aluminum alloy layer and an photolithography or wet process etching for removing the protective layer are difficult. Moreover, in the case where the countermeasure of changing electrodes and wiring materials from aluminum or aluminum alloy to metals having resistance against alkaline etchant, there was a problem that the use of metallic material other than aluminum causes contamination in processing equipment, etc.

On the other hand, with regard to an organic alkali base etching agent, in comparison with the alkali base etching agent comprising metal hydroxide aqueous solution as a main component, the former is superior in anisotropic etching property, low damage to mask materials, good matching with semiconductor process, etc. However, there was a problem that the silicon etching rate in face (100) of silicon mainly used as etching face of the manufacturing of micro-structures of silicon relating to the present invention is as small as 1/3 to 1/2 compared with the etching agent comprising the metal hydroxide aqueous solution as the main component. On the assumption that the etching agent as aqueous solution of the tetramethylammonium hydroxide with a concentration of 22 % by weight is used at the temperature of 80 °C in order to provide a via hole in a silicon single-crystal wafer with a thickness of 725 µm, it is extremely disadvantageous in an aspect of manufacture process because about 20 hours are required for providing the via hole. Except the via hole, a process of etching silicon to a depth of several hundreds µm will also require ten and several hours and as a result, it is also extremely disadvantageous in the aspect of manufacture process.

### SUMMARY OF INVENTION

The invention is as defined in the claims.

Taking the foregoing circumstances into consideration, an object of the present invention is to provide an etching method for silicon with the use of an etching agent composition both capable of shortening the process time for silicon etching while maintaining etching property such as a ratio of etching rates depending on silicon crystal face or in a smoothness of etching surface, and at the same time, improving the etching rate; and capable of anisotropic etching only silicon selectively without etching aluminum or aluminum alloy frequently used as electrodes or wiring materials.

As a result of intensive researches and studies to achieve the above object by the present inventors, it was found that using an alkaline base etching agent composition having a composition of an alkaline aqueous solution adding hydroxylamines has a superior property of improving the etching rate of silicon etching while maintaining etching property such as a ratio of etching rates depending on silicon crystal face or in a smoothness of etching surface. The present invention has been completed on the basis of the findings. Further, it was also found that an alkali base etching agent composition adding saccharide, alcohol saccharides, pyrocatechol or butylcatechol as a corrosion inhibitor for aluminum or aluminum alloy enables to etch only silicon selectively without etching aluminum or aluminum alloy frequently used as electrodes or wiring materials. Such being the case, the present invention has been accomplished on the basis of the foregoing findings and information. Namely, the present invention provides the use of a composition for anisotropically etching silicon to manufacture micro-structures of silicon, said composition comprising an alkali compound and hydroxylamines. Also, the present invention provides the use of said composition for manufacturing of micro-structures of silicon further comprising saccharide, alcohol saccharides, pyrocatechol or butylcatechol as a corrosion inhibitor for aluminum or aluminum alloy.

The present invention enables etching adaptively applicable for manufacturing of micro-structures of silicon with a rapid etching rate. The possibility of enhancing the etching rate while maintaining particularly fundamental concentration and composition of the alkali compound and maintaining the etching property is extremely efficient in manufacture process with the use of manufacturing of micro-structures of silicon. Further, the possibility of etching only silicon selectively without etching aluminum or aluminum alloy used frequently as electrodes or wiring materials is extremely efficient because it excitingly improves productivity in the manufacture process with the use of manufacturing of micro-structures of silicon.

### THE PREFERRED EMBODIMENT TO CARRY OUT THE INVENTION

The alkali compound used in the present invention is an organic alkali compound selected from the group consisting of tetramethyl ammonium hydroxide, choline, and ethylenediamine. Among these, tetramethylammonium hydroxide and choline are preferable and tetramethylammonium hydroxide is particularly preferable as the organic alkali compound. They may be used alone or in combination of two or more kinds thereof.

The alkali compound used may also be an inorganic alkali compound selected from the group consisting of sodium hydroxide, potassium hydroxide, and hydrated hydrazine. They may be used alone or in combination of two or more kinds thereof, and a combination of potassium hydroxide and ammonia may be also employable.

Moreover, a combination of the inorganic alkali compound and the organic alkali compound may be also employable depending on necessity.

Regarding with the concentration of the organic alkali compound, it is appropriately determined depending on its solubility to water in the etching agent composition and on the additive concentration added in the composition, however, within the range of from 0.1 to 40 % by weight is preferable. When the concentration is 0.1 % by weight or lower, a silicon etching rate is very slow or etching does not advance. When the concentration exceeds 40 % by weight, it is not favorable because separating of crystals or solidification will occur among the etching agent composition. Moreover, a combination with an alkali compound such as ammonium hydroxide used frequently in a semiconductor process may be acceptable in an extent which does not obstruct the effect of the present invention.

Regarding with the concentration of the alkali compound employed in the present invention may be conventional concentration of the alkali compound for getting desired etching property. However, it may be appropriately determined depending on its solubility to water in the etching agent composition and on the additive concentration added in the composition. Namely, it is preferably within a range of from 0.1 to 65 % by weight, and more preferably within a range of from 1 to 40 % by weight.

When the concentration is 0.1 % by weight or lower, a silicon etching rate is very slow or etching does not advance. When the concentration exceeds 65 % by weight, it is not favorable because separating of crystal or solidification will occur among the etching agent composition.

The hydroxylamines employed in the present invention are selected from a group consisting of hydroxylamine, hydroxylamine sulfate, hydroxylamine chloride, hydroxylamine oxalate, hydroxylamine phosphate, dimethyl hydroxylamine. Preferable examples include hydroxylamine, hydroxylamine sulfate, hydroxylamine chloride, hydroxylamine oxalate and hydroxylamine phosphate. Hydroxylamine is the most preferable hydroxylamines employed in the present invention.

They may be used alone or in combination of two or more kinds thereof. Further, regarding with the concentration of the hydroxylamines, it is appropriately determined depending on its solubility to water in the hydroxylamines, on the concentration of the alkali compound among the etching agent composition and on the additive concentration added in the composition, however, within a range of from 0.1 to 50 % by weight is preferable, and within a range of from 1 to 40 % by weight is more preferable. When the concentration is under 0.1 % by weight, any desired improvement of silicon etching rate is impossible. When the concentration exceeds 50 % by weight, it is not favorable because separating of crystal or solidification will occur among the etching agent composition, or because an flashing point appears in the etching agent composition rendering uneasy handling property.

As a component contained in the etching agent composition except the alkali compound and the hydroxylamines, there are pyrocatechol, butyl pyrocatechol, saccharide, saccharide alcohols as a corrosion inhibitor for aluminum or aluminum alloy. Examples of saccharide or saccharide alcohols include arabinose, galactose, xylitol, sorbitol, mannitol, mannose, glucose, lactose, maltol, maltose, inositol, xylose, threose, erythrose, ribose, ribulose, xylulose, tagatose, allose, altrose, gulose, idose, talose, sorbose, psicose, fructose, threitol, erythritol, adonitol, arabitol, talitol, iditol, dulcitol, trehalose, sucrose, polydextrose, etc. Among these, preferable examples are arabinose, galactose, xylitol, sorbitol, mannitol, mannose, glucose, lactose, maltol, maltose, inositol and xylose; xylitol and sorbitol being more preferable.

Any other conventional additives may be employed in combination with the etching agent composition. Further, a surfactant may be also preparedly added into the etching agent composition for the purpose of dissolving silicon or of enhancing wetting ability, if desired. Any surfactant, for example, such as cation base, nonion base or anion base is employable as the surfactant. On the other hand, a decomposition inhibitor for a purpose of inhibiting decomposition of the additives, an additive or an organic solvent for a purpose of controling an etching rate of silicon may be added to the etching agent composition . Alcohol, glycerin or glycerin derivative is preferable as the additives. Typical examples of alcohol include methanol, ethanol, isopropyl alcohol, n-propyl alcohol, isobutanol and n- butylalcohol, and typical examples of glycerin derivative include diglycerol and polyglycerol. With regard to pH of the etching agent composition , it is effective to be alkaline higher than 7, however, it is preferable that the pH is 11 or higher. Additionally, there are two functions as a corrosion inhibitor for aluminum and a decomposition inhibitor for hydroxylamine regarding with the pyrocatechol.

The anisotropic etching method for manufacturing of micro-structures of silicon in the present invention ordinarily comprises the steps of soaking articles to be treated into the etching agent composition after heating; taking out after a passage of a predetermined time; rinsing with water or so in order to remove the etching agent composition accompanied to the articles; followed by drying. Regarding with the working temperature of the etching agent composition, it is preferable to be in a range of from ordinary temperature up to the flashing point of the etching agent composition from the aspect of facility and safety. Further, in the case where the flashing point is absent in the etching agent composition, the working temperature is preferable to be in a range of from ordinary temperature up to a boiling point of the etching agent composition. However, in the case where some effective safety measures are applied to the processing apparatus, the working temperature outside the above range may be employable. Still further, a use of the etching agent composition under a compressed pressure may be applicable for the purpose of getting faster etching rate in employing an elevated temperature.

The etching agent composition is mainly used for etching of a silicon single-crystal because the features of the etching agent composition is an etching capability to silicon, and a crystallinity of the silicon single-crystal enables to take advantage of an anisotropic etching property whose etching rate is different in crystal face orientation. To be specific, after film-forming of silicon oxide film or silicon nitride film over the silicon substrate consisting of the silicon single-crystal, forming patterns over the silicon substrate by etching the above silicon oxide film or silicon nitride film with a use of a resist having patterning performed as a mask over the top of the film, and then, carring out anisotropic etching on the silicon substrate with the use of the etching agent composition of the present invention. In addition, the anisotropic etching for silicon substrate consisting of the silicon single-crystal preparedly patterned with metals such as aluminum used as wirings or elements in electronic instrument such as a velocity sensor or so may be exemplified. In an occasion of the etching agent composition aims to anisotropic etching for the silicon single-crystal utilizing the difference of etching rate in crystal face orientation, examples of the material to be treated include silicon, polysilicon, and crystalline silicons such as doped polysilicon made by ion-doping these materials. The examples further include whole silicon base materials such as silicon oxide film, silicon nitride film and silicon organic film or metals such as aluminum dissolvable with alkaline water solution. Still further, a coexistence of two or more kinds of the above materials in the articles to be treated may be possible. Also, the examples further include the above materials over which a resist is applied for forming a film, and those articles among which a pattern configuration containing metals such as aluminum was built in the structure even while they do not directly contact with the anisotropic etching agent composition.

Although the silicon etching method in the present invention is applied for MEMS manufacture having the deep silicon etching process mainly taking advantage of the anisotropic etching, it may be applied for the manufacture such as semiconductor integrated circuits or flat panel display devices. Examples of the electronic instrument having a silicon substrate processed by means of the etching method in the present invention include acceleration sensor, angular velocity sensor, semiconductor pressure sensor, flow sensor, ink jet printer head, etc.

### EXAMPLES

The present invention shall be explained below in further details with reference to Examples and Comparative Examples. In the Examples, "%" means % by weight. A sample for evaluation was prepared by soaking a silicon single-crystal wafer, on one surface of which a pattern by silicon thermal oxidation film was formed and on the other surface of which a protection film was formed by silicon thermal oxidation, into 1 % hydrofluoric acid aqueous solution at an ordinary temperature for 3 minutes, rinsing with ultra pure water (UPW), and removing only naturally oxidized film over the surface of the single-crystal after drying. The sample was used in Examples and Comparative Examples below.

### Example 1

An aqueous solution containing 10 % tetramethylammonium hydroxide and 10 % hydroxylamine was employed as an etching agent, and the sample for evaluation was soaked into the etching agent at the temperature of 80 °C. After soaking the sample for 2 hours, the sample was taken out from the etching agent and it was dried after UPW rinsing. An etching amount of the sample was measured in face (100) orientation and in face (111) orientation of the silicon single-crystal after rinsing, and as a result, it was about 186 µm in face (100) orientation. The etching amount was about 12 µm in face (111) orientation.

### Example 2

An aqueous solution containing 10 % tetramethylammonium hydroxide and 5 % hydroxylamine sulfate was employed as the etching agent, and after the same treatment as Example 1 was carried out, the amount of silicon etching was measured and as a result, it was about 150 µm in face (100) orientation. The etching amount was about 7 µm in face (111) orientation.

### Example 3

An aqueous solution containing 10 % tetramethylammonium hydroxide and 5 % hydroxylamine chloride was employed as the etching agent, and after the same treatment as Example 1 was carried out, the amount of silicon etching was measured and as a result, it was about 156 µm in face (100) orientation. The etching amount was about 11 µm in face (111) orientation.

### Example 4

An aqueous solution containing 10 % tetramethylammonium hydroxide and 5 % hydroxylamine phosphate was employed as the etching agent, and after the same treatment as Example 1 was carried out, the amount of silicon etching was measured and as a result, it was about 142 µm in face (100) orientation. The etching amount was about 9 µm in face (111) orientation.

### Example 5

An aqueous solution containing 10 % tetramethylammonium hydroxide and 5 % hydroxylamine oxalate was employed as the etching agent, and after the same treatment as Example 1 was carried out, the amount of silicon etching was measured and as a result, it was about 144 µm in face (100) orientation. The etching amount was about 6 µm in face (111) orientation.

### Example 6

An aqueous solution containing 10 % tetramethylammonium hydroxide and 5 % dimethylhydroxylamine was employed as the etching agent, and after the same treatment as Example 1 was carried out, the amount of silicon etching was measured and as a result, it was about 116 µm in face (100) orientation. The etching amount was about 4 µm in face (111) orientation.

### Example 7

An aqueous solution containing 10 % potassium hydroxide and 5 % hydroxylamine sulfate was employed as the etching agent, and after a similar treatment as Example 1 was carried out except that soaking time being 1 hour, the amount of silicon etching was measured and as a result, it was about 122 µm in face (100) orientation. The etching amount was about 2 µm in face (111) orientation.

### Example 8

An aqueous solution containing 10 % tetramethylammonium hydroxide and 5 % hydroxylamine chloride was employed as the etching agent, and after the same treatment as Example 7 was carried out, the amount of silicon etching was measured and as a result, it was about 141 µm in face (100) orientation. The etching amount was about 3 µm in face (111) orientation.

### Example 9

An aqueous solution containing 10 % tetramethylammonium hydroxide and 5 % hydroxylamine oxalate was employed as the etching agent, and after the same treatment as Example 1 was carried out, the amount of silicon etching was measured and as a result, it was about 131 µm in face (100) orientation. The etching amount was about 2 µm in face (111) orientation.

### Comparative Example 1

An aqueous solution containing 10 % tetramethylammonium hydroxide was employed as the etching agent, and after the same treatment as Example 1 was carried out, the amount of silicon etching was measured and as a result, it was about 88 µm in face (100) orientation and was 3 µm in face (111) orientation.

### Comparative Example 2

An aqueous solution containing 0.05 % tetramethylammonium hydroxide was employed as the etching agent, and after the same treatment as Example 1 was carried out, the amount of silicon etching was measured and as a result, it was up to 1 µm in face (100) orientation and was also up to 1 µm in face (111) orientation.

### Comparative Example 3

An aqueous solution containing 20 % tetramethylammonium fluoride was employed as the etching agent, and after the same treatment as Example 1 was carried out, the amount of silicon etching was measured and as a result, it was up to 1 µm in face (100) orientation and was also up to 1 µm in face (111) orientation.

### Comparative Example 4

An aqueous solution containing 1 % hydrogen fluoride was employed as the etching agent, and after the same treatment as Example 1 was carried out, the amount of silicon etching was measured and as a result, it was up to 1 µm in face (100) orientation and was also up to 1 µ m in face (111) orientation.

### Comparative Example 5

An aqueous solution containing 20 % hydroxylamine was employed as the etching agent, and after the same treatment as Example 1 was carried out, the amount of silicon etching was measured and as a result, it was up to 1 µm in face (100) orientation. The etching amount was also up to 1 µm in face (111) orientation.

### Comparative Example 6

An aqueous solution containing 10 % tetramethylammonium hydroxide and 5 % hydrazine was employed as the etching agent, and after the same treatment as Example 1 was carried out, the amount of silicon etching was measured and as a result, it was about 115 µm in face (100) orientation. The etching amount was about 5 µm in face (111) orientation.

### Comparative Example 7

An aqueous solution containing 10 % tetramethylammonium hydroxide and 5 % ammonium hypophosphite was employed as the etching agent, and after the same treatment as Example 1 was carried out, the amount of silicon etching was measured and as a result, it was about 112 µm in face (100) orientation. The etching amount was about 5 µm in face (111) orientation.

Exactly as verified in the above Examples and Comparative Examples, additions of tetramethylammonium hydroxide aqueous solution, potassium hydroxide as alkali compounds and hydroxylamines enhance the etching rate in face (100) orientation 1.5 times or greater than tetramethylammonium hydroxide aqueous solution with the same concentration, than potassium hydroxide aqueous solution with the same concentration, than simple hydroxylamine aqueous solution with the same concentration or than a dilute solution made by combining them. Further, it is apparent that although an addition of hydrazine or ammonium hypophosphate as a reductive agent except hydroxylamines only slightly increases the etching rate in face (100) orientation over tetramethylammonium hydroxide aqueous solution with the same concentration, an enhancement of 1.5 times or greater obtained by the hydroxylamines was not recognized. The fact verifies that the hydroxylamines reveal a peculiar effect among reductive agents.

### Example 10

An aqueous solution containing 10 % tetramethylammonium hydroxide, 10 % hydroxylamine and 40 % glycerin was employed as the etching agent, and after the same treatment as Example 1 was carried out, the amount of silicon etching was measured and as a result, it was about 147 µm in face (100) orientation. The etching amount was about 4 µm in face (111) orientation.

### Comparative Example 8

An aqueous solution containing 10 % tetramethylammonium hydroxide and 40 % glycerin was employed as the etching agent, and after the same treatment as Example 1 was carried out, the amount of silicon etching was measured and as a result, it was about 76 µm in face (100) orientation. The etching amount was about 3 µm in face (111) orientation.

Exactly as verified in the above Example and Comparative Example, additions of hydroxylamines and glycerin as an organic solvent into tetramethylammonium hydroxide aqueous solution as an organic alikali enhance the etching rate in face (100) orientation over an aqueous solution containing tetramethylammonium hydroxide aqueous solution and glycerin with the same concentration.

### Example 11 not forming part of the invention

An aqueous solution containing 10 % tetraethylammonium hydroxide and 10 % hydroxylamine was employed as the etching agent, and after the same treatment as Example 1 was carried out, the amount of silicon etching was measured and as a result, it was about 70 µm in face (100) orientation. The etching amount was about 4 µm in face (111) orientation.

### Comparative Example 9

An aqueous solution containing 10 % tetraethylammonium hydroxide was employed as the etching agent, and after the same treatment as Example 1 was carried out, the amount of silicon etching was measured and as a result, it was about 53 µm in face (100) orientation. The etching amount was about 5 µm in face (111) orientation.

Exactly as verified in the above Example 11 not forming part of the invention and Comparative Example, an addition of hydroxylamine to the alkali aqueous solution even under a usage of tetraethylammonium hydroxide instead of tetramethylammonium hydroxide as the organic alkali also enhances the etching rate in face (100) orientation over tetraethylammonium hydroxide aqueous solution with the same concentration.

### Example 12

An aqueous solution containing 10 % tetramethylammonium hydroxide, 10 % hydroxylamine and 5 % sorbitol was employed as the etching agent, and after the same treatment as Example 1 was carried out, the amount of silicon etching was measured and as a result, it was about 165 µm in face (100) orientation. The etching amount was about 9 µm in face (111) orientation.

### Example 13

An aqueous solution containing 10% tetramethylammonium hydroxide, 10% hydroxylamine and 5% xylitol was employed as the etching agent, and after the same treatment as Example 1 was carried out, the amount of silicon etching was measured and as a result, it was about 167 µm in face (100) orientation. The etching amount was about 9 µm in face (111) orientation.

### Comparative Example 10

An aqueous solution containing 10 % tetramethylammonium hydroxide and 5 % sorbitol was employed as the etching agent, and after the same treatment as Example 1 was carried out, the amount of silicon etching was measured and as a result, it was about 71 µm in face (100) orientation. The etching amount was about 3 µm in face (111) orientation.

### Comparative Example 11

An aqueous solution containing 10 % tetramethylammonium hydroxide and 5 % xylitol was employed as the etching agent, and after the same treatment as Example 1 was carried out, the amount of silicon etching was measured and as a result, it was about 76 µm in face (100) orientation. The etching amount was about 3 µm in face (111) orientation.

With a use of a sample prepared by film-forming aluminum-silicon alloy of about 500 nm in thickness over a silicon substrate, the etching rate was measured by conducting soaking treatment about the sample in various kinds of chemical solutions at an ordinary temperature. To be specific, by measuring the thickness of the aluminum-silicon film before and after the soaking treatment in the chemical solution, the etching rate was calculated from a reduced amount in film thickness of the aluminum-silicon film.

The following are Examples not forming part of the invention and Comparative Examples regarding with the etching rate.

### Example 14

The film-formed sample of aluminum-silicon alloy was soaked into an aqueous solution containing 10 % tetramethylammonium hydroxide and 10 % hydroxylamine at the temperature of 30 °C. An etching rate was calculated from the reduced amount in film thickness of the aluminum-silicon film and as a result, it was 30 nm/min.

### Comparative Example 12

The film-formed sample of aluminum-silicon alloy was soaked into aqueous solution containing 10 % tetramethylammonium hydroxide and at the temperature of 30 °C. An etching rate was calculated from the reduced amount in film thickness of the aluminum-silicon film and as a result, it was 90 nm/min or faster.

### Example 15

The film-formed sample of aluminum-silicon alloy was soaked into an aqueous solution containing 10 % tetramethylammonium hydroxide,10 % hydroxylamine and 5 % sorbitol at the temperature of 30 °C. The etching rate was calculated from the reduced amount in film thickness of the aluminum-silicon film and as a result, it was 15 nm/min.

### Comparative Example 13

The film-formed sample of aluminum-silicon alloy was soaked into an aqueous solution containing 10 % tetramethylammonium hydroxide and 5 % sorbitol at the temperature of 30 °C. The etching rate was calculated from the reduced amount in film thickness of the aluminum-silicon film and as a result, it was 55 nm/min.

### Example 16

The film-formed sample of aluminum-silicon alloy was soaked into an aqueous solution containing 10 % tetramethylammonium hydroxide, 10 % hydroxylamine and 5 % xylitol at the temperature of 30 °C. The etching rate was calculated from the reduced amount in film thickness of the aluminum-silicon film and as a result, it was 11 nm/min.

### Comparative Example 14

The film-formed sample of aluminum-silicon alloy was soaked into an aqueous solution containing 10 % tetramethylammonium hydroxide and 5 % xylitol at the temperature of 30 °C. The etching rate was calculated from the reduced amount in film thickness of the aluminum-silicon film and as a result, it was 43 nm/min.

### Example 17

The film-formed sample of aluminum-silicon alloy was soaked into an aqueous solution containing 10 % tetramethylammonium hydroxide, 10 % hydroxylamine and 5% catechol at the temperature of 30 °C. The etching rate was calculated from the reduced amount in film thickness of the aluminum-silicon film and as a result, it was 5 nm/min.

### Comparative Example 15

The film-formed sample of aluminum-silicon alloy was soaked into an aqueous solution containing 10 % tetramethylammonium hydroxide and 5 % catechol at the temperature of 30 °C. The etching rate was calculated from the reduced amount in film thickness of the aluminum-silicon film and as a result, it was 43 nm/min.

### Example 18

The film-formed sample of aluminum-silicon alloy was soaked into an aqueous solution containing 10 % tetramethylammonium hydroxide, 10 % hydroxylamine and 5 % butylcatechol at the temperature of 30 °C. The etching rate was calculated from the reduced amount in film thickness of the aluminum-silicon film and as a result, it was 12 nm/min.

### Comparative Example 16

The film-formed sample of aluminum-silicon alloy was soaked into an aqueous solution containing 10 % tetramethylammonium hydroxide and 5 % butylcatechol at the temperature of 30 °C. The etching rate was calculated from the reduced amount in film thickness of the aluminum-silicon film and as a result, it was 94 nm/min.

### Example 19

The film-formed sample of aluminum-silicon alloy was soaked into an aqueous solution containing 10 % tetramethylammonium hydroxide, 10 % hydroxylamine and 5% arabinose at the temperature of 30 °C. The etching rate was calculated from the reduced amount in film thickness of the aluminum-silicon film and as a result, it was 13 nm/min.

### Comparative Example 17

The film-formed sample of aluminum-silicon alloy was soaked into an aqueous solution containing 10 % tetramethylammonium hydroxide and 5 % arabinose at the temperature of 30 °C. The etching rate was calculated from the reduced amount in film thickness of the aluminum-silicon film and as a result, it was 50 nm/min.

### Example 20

The film-formed sample of aluminum-silicon alloy was soaked into an aqueous solution containing 10 % tetramethylammonium hydroxide, 10 % hydroxylamine and 5 % galactose at the temperature of 30 °C. The etching rate was calculated from the reduced amount in film thickness of the aluminum-silicon film and as a result, it was 17 nm/min.

### Comparative Example 18

The film-formed sample of aluminum-silicon alloy was soaked into an aqueous solution containing 10 % tetramethylammonium hydroxide and 5 % galactose at the temperature of 30 °C. The etching rate was calculated from the reduced amount in film thickness of the aluminum-silicon film and as a result, it was 87 nm/min.

### Example 21

The film-formed sample of aluminum-silicon alloy was soaked into an aqueous solution containing 10 % tetramethylammonium hydroxide, 10 % hydroxylamine and 5 % ribose at the temperature of 30 °C. The etching rate was calculated from the reduced amount in film thickness of the aluminum-silicon film and as a result, it was 19 nm/min.

### Comparative Example 19

The film-formed sample of aluminum-silicon alloy was soaked into an aqueous solution containing 10% tetramethylammonium hydroxide and 5 % ribose at the temperature of 30 °C. The etching rate was calculated from the reduced amount in film thickness of the aluminum-silicon film and as a result, it was 81 nm/min.

### Example 22

The film-formed sample of aluminum-silicon alloy was soaked into an aqueous solution containing 10 % tetramethylammonium hydroxide, 10 % hydroxylamine and 5 % mannose at the temperature of 30 °C. The etching rate was calculated from the reduced amount in film thickness of the aluminum-silicon film and as a result, it was 21 nm/min.

### Comparative Example 20

The film-formed sample of aluminum-silicon alloy was soaked into an aqueous solution containing 10 % tetramethylammonium hydroxide and 5% mannose at the temperature of 30 °C. The etching rate was calculated from the reduced amount in film thickness of the aluminum-silicon film and as a result, it was 90 nm/min or faster.

### Example 23

The film-formed sample of aluminum-silicon alloy was soaked into an aqueous solution containing 10 % tetramethylammonium hydroxide, 10 % hydroxylamine and 5 % glucose at the temperature of 30 °C. The etching rate was calculated from the reduced amount in film thickness of the aluminum-silicon film and as a result, it was 20 nm/min.

### Comparative Example 21

The film-formed sample of aluminum-silicon alloy was soaked into an aqueous solution containing 10 % tetramethylammonium hydroxide and 5 % glucose at the temperature of 30 °C. The etching rate was calculated from the reduced amount in film thickness of the aluminum-silicon film and as a result, it was 90 nm/min or faster.

### Example 24

The film-formed sample of aluminum-silicon alloy was soaked into an aqueous solution containing 10 % tetramethylammonium hydroxide, 10 % hydroxylamine and 5 % lactose at the temperature of 30 °C. The etching rate was calculated from the reduced amount in film thickness of the aluminum-silicon film and as a result, it was 20 nm/min.

### Comparative Example 22

The film-formed sample of aluminum-silicon alloy was soaked into an aqueous solution containing 10 % tetramethylammonium hydroxide and 5 % lactose at the temperature of 30 °C. The etching rate was calculated from the reduced amount in film thickness of the aluminum-silicon film and as a result, it was 81 nm/min.

### Example 25

The film-formed sample of aluminum-silicon alloy was soaked into an aqueous solution containing 10 % tetramethylammonium hydroxide, 10 % hydroxylamine and 5 % maltol at the temperature of 30 °C. The etching rate was calculated from the reduced amount in film thickness of the aluminum-silicon film and as a result, it was 11 nm/min.

### Comparative Example 23

The film-formed sample of aluminum-silicon alloy was soaked into an aqueous solution containing 10 % tetramethylammonium hydroxide and 5 % maltol at the temperature of 30 °C. The etching rate was calculated from the reduced amount in film thickness of the aluminum-silicon film and as a result, it was 90 nm/min or faster.

### Example 26

The film-formed sample of aluminum-silicon alloy was soaked into an aqueous solution containing 10 % tetramethylammonium hydroxide, 10 % hydroxylamine and 5 % maltose at the temperature of 30 °C. The etching rate was calculated from the reduced amount in film thickness of the aluminum-silicon film and as a result, it was 13 nm/min.

### Comparative Example 24

The film-formed sample of aluminum-silicon alloy was soaked into an aqueous solution containing 10 % tetramethylammonium hydroxide and 5 % maltose at the temperature of 30 °C. The etching rate was calculated from the reduced amount in film thickness of the aluminum-silicon film and as a result, it was 79 nm/min.

### Example 27

The film-formed sample of aluminum-silicon alloy was soaked into an aqueous solution containing 10 % tetramethylammonium hydroxide, 10 % hydroxylamine and 5 % inositol at the temperature of 30 °C. The etching rate was calculated from the reduced amount in film thickness of the aluminum-silicon film and as a result, it was 11 nm/min.

### Comparative Example 25

The film-formed sample of aluminum-silicon alloy was soaked into an aqueous solution containing 10 % tetramethylammonium hydroxide and 5% inositol at the temperature of 30 °C. The etching rate was calculated from the reduced amount in film thickness of the aluminum-silicon film and as a result, it was 65 nm/min.

### Example 28

The film-formed sample of aluminum-silicon alloy was soaked into an aqueous solution containing 10 % tetramethylammonium hydroxide, 10 % hydroxylamine and 5 % xylose at the temperature of 30 °C. The etching rate was calculated from the reduced amount in film thickness of the aluminum-silicon film and as a result, it was 9 nm/min.

### Comparative Example 26

The film-formed sample of aluminum-silicon alloy was soaked into an aqueous solution containing 10 % tetramethylammonium hydroxide and 5 % xylose at the temperature of 30 °C. The etching rate was calculated from the reduced amount in film thickness of the aluminum-silicon film and as a result, it was 90 nm/min or faster.

### Example 29

The film-formed sample of aluminum-silicon alloy was soaked into an aqueous solution containing 10 % tetramethylammonium hydroxide, 10 % hydroxylamine and 5 % trehalose at the temperature of 30 °C. The etching rate was calculated from the reduced amount in film thickness of the aluminum-silicon film and as a result, it was 23 nm/min.

### Comparative Example 27

The film-formed sample of aluminum-silicon alloy was soaked into an aqueous solution containing 10 % tetramethylammonium hydroxide and 5 % trehalose at the temperature of 30 °C. The etching rate was calculated from the reduced amount in film thickness of the aluminum-silicon film and as a result, it was 90nm/min or faster.

### Example 30

The film-formed sample of aluminum-silicon alloy was soaked into an aqueous solution containing 10 % tetramethylammonium hydroxide, 10 % hydroxylamine and 5 % sucrose at the temperature of 30 °C. The etching rate was calculated from the reduced amount in film thickness of the aluminum-silicon film and as a result, it was 28 nm/min.

### Comparative Example 28

The film-formed sample of aluminum-silicon alloy was soaked into an aqueous solution containing 10 % tetramethylammonium hydroxide and 5 % sucrose at the temperature of 30 °C. The etching rate was calculated from the reduced amount in film thickness of the aluminum-silicon film and as a result, it was 90 nm/min or faster.

### Example 31

The film-formed sample of aluminum-silicon alloy was soaked into an aqueous solution containing 10 % tetramethylammonium hydroxide, 10 % hydroxylamine and 5 % fructose at the temperature of 30 °C. The etching rate was calculated from the reduced amount in film thickness of the aluminum-silicon film and as a result, it was 21 nm/min.

### Comparative Example 29

The film-formed sample of aluminum-silicon alloy was soaked into an aqueous solution containing 10% tetramethylammonium hydroxide and 5 % fructose at the temperature of 30 °C. The etching rate was calculated from the reduced amount in film thickness of the aluminum-silicon film and as a result, it was 90 nm/min or faster.

### Example 32

The film-formed sample of aluminum-silicon alloy was soaked into an aqueous solution containing 10 % tetramethylammonium hydroxide, 10 % hydroxylamine and 5 % polydextrose at the temperature of 30 °C. The etching rate was calculated from the reduced amount in film thickness of the aluminum-silicon film and as a result, it was 21 nm/min.

### Comparative Example 30

The film-formed sample of aluminum-silicon alloy was soaked into an aqueous solution containing 10 % tetramethylammonium hydroxide and 5 % polydextrose at the temperature of 30 °C. The etching rate was calculated from the reduced amount in film thickness of the aluminum-silicon film and as a result, it was 90 nm/min or faster.

Exactly as verified in the above Examples not forming part of the invention and Comparative Examples, additions of tetramethylammonium hydroxide aqueous solution, potassium hydroxide as alkali compounds, and hydroxylamines and pyrocatechol, butylcatechol, saccharide or alcohol saccharides as a corrosion inhibitor for aluminum or aluminum alloy regulate etching the aluminum-silicon alloy as compared with the aqueous solution containing tetramethylammonium hydroxide aqueous solution with the same concentration.

### INDUSTRIAL APPLICABILITY

As described in Examples and Comparative Examples, the present invention enables the anisotropic etching for manufacturing of micro-structures of silicon with favorably rapid etching rate. The possibility of enhancing the etching rate while maintaining particularly fundamental concentration and composition of the alkali compound and maintaining the etching property is extremely efficient in manufacturing of micro-structures of silicon. Further, the possibility of etching only silicon selectively without etching aluminum or aluminum alloy frequently used as electrodes or wiring materials is extremely efficient because it excitingly improves productivity in the manufacturing of micro-structures of silicon.

## Claims

1. Use of a composition for anisotropically etching silicon to manufacture micro-structures of silicon, wherein the composition comprises at least an alkali compound selected from the group consisting of tetramethylammonium hydroxide, choline, ethylenediamine, sodium hydroxide, potassium hydroxide and hydrated hydrazine, and at least a hydroxylamine compound selected from the group consisting of hydroxylamine, hydroxylamine sulfate, hydroxylamine chloride, hydroxylamine phosphate, hydroxylamine oxalate, and dimethyl hydroxylamine.

2. Use of a composition according to Claim 1, wherein the composition further comprises a corrosion inhibitor selected from the group consisting of arabinose, galactose, xylitol, sorbitol, mannitol, mannose, glucose, lactose, maltol, maltose, inositol, xylose, trehalose, sucrose, fructose, polydextrose, threose, erythrose, ribose, ribulose, xylulose, tagatose, allose, altrose, gulose, idose, talose, sorbose, psicose, threitol, erythritol, adonitol, arabitol, talitol, iditol and dulcitol.

3. Use of the composition according to Claim 1 or 2, wherein the amount of the alkali compound is from 1 to 40 % by weight and the mount of the hydroxylamine compound Is from 0.1 to 50 % by weight.

4. Use of the composition according to Claim 1 or 2, wherein the alkali compound is tetramethylammonium hydroxide.

5. Use of the composition according to Claim 1 or 2, wherein the alkali compound is potassium hydroxide and the composition further comprises ammonia.

6. Use of the composition according to Claim 5, wherein the amount of potassium hydroxide combined with ammonia is from 0.1 to 65 % by weight and the amount of hydroxylamine compound is from 0.1 to 50 % by weight.

7. Use of the composition according Claim 1, wherein the composition further comprises one kind selected from the group consisting of an alcohol selected from the group consisting of methanol, ethanol, isopropyl alcohol, n-propylalcohol, isobutanol, and n-butyl alcohol, pyrocatechol, butylcatechol, glycerine and glycerine derivative.

## Patentansprüche

1. Verwendung einer Zusammensetzung zum anisotropen Ätzen von Silicium zur Herstellung von Mikrostrukturen von Silicium, wobei die Zusammensetzung mindestens eine Alkaliverbindung, die ausgewählt ist aus der Gruppe, bestehend aus Tetramethylammoniumhydroxid, Cholin, Ethylendiamin, Natriumhydroxid, Kaliumhydroxid und Hydrazinhydrat, und mindestens eine Hydroxylaminverbindung, die aus der Gruppe ausgewählt ist, bestehend aus Hydroxylamin, Hydroxylaminsulfat, Hydroxylaminchlorid, Hydroxylaminphosphat, Hydroxylaminoxalat und Dimethylhydroxylamin, umfasst.

2. Verwendung einer Zusammensetzung nach Anspruch 1, wobei die Zusammensetzung weiterhin einen Inhibitor umfasst, der aus der Gruppe ausgewählt ist, bestehend aus Arabinose, Galactose, Xylit, Sorbit, Mannit, Mannose, Lactose, Maltol, Maltose, Inosit, Xylose, Trehalose, Saccharose, Fructose, Polydextrose, Threose, Erythrose, Ribose, Ribulose, Xylulose, Tagatose, Allose, Altrose, Gulose, Idose, Talose, Sorbose, Psicose, Threit, Erythrit, Adonit, Arabit, Tallitol, Idit und Dulcit.

3. Verwendung der Zusammensetzung nach Anspruch 1 oder 2, wobei die Menge der Alkaliverbindung 1 bis 40 Gew.-% beträgt und die Menge der Hydroxylamin-Verbindung von 0,1 bis 50 Gew.-% beträgt.

4. Verwendung der Zusammensetzung nach Anspruch 1 oder 2, wobei die AlkaliVerbindung Tetramethylammoniumhydroxid ist.

5. Verwendung der Zusammensetzung nach Anspruch 1 oder 2, wobei die AlkaliVerbindung Kaliumhydroxid ist und die Zusammensetzung weiterhin Ammoniak umfasst.

6. Verwendung der Zusammensetzung nach Anspruch 5, wobei die Menge an Kaliumhydroxid in Kombination mit Ammoniak 0,1 bis 65 Gew.-% beträgt und die Menge der Hydroxylamin-Verbindung von 0,1 bis 50 Gew.-% beträgt.

7. Verwendung der Zusammensetzung nach Anspruch 1, wobei die Zusammensetzung weiterhin eine Art umfasst, die aus der Gruppe ausgewählt ist, bestehend aus einem Alkohol, der aus der Gruppe ausgewählt ist, bestehend aus Methanol, Ethanol, Isopropylalcohol, n-Propylalkohol, Isobutanol und n-Butylalkohol, Pyrocatechol, Butylcatechol, Glycerin und Glycerinderivat.

## Revendications

1. Utilisation d'une composition pour la gravure anisotrope de silicium pour la production de microstructures en silicium, dans laquelle le composition comprend au moins un composé alcalin sélectionné parmi le groupe consistant en l'hydroxyde de tétraméthylammonium, la choline, l'éthylène diamine, l'hydroxyde de sodium, l'hydroxyde de potassium et l'hydrazine hydraté, et au moins un composé d'hydroxylamine, sélectionné parmi le groupe consistant en l'hydroxylamine, le sulfate d'hydroxylamine, le chlorure d'hydroxylamine, le phosphate d'hydroxylamine, l'oxalate d'hydroxylamine, et la diméthyl-hydroxylamine.

2. Utilisation d'une composition selon la revendication 1, dans laquelle la composition comprend en outre un inhibiteur selectionné parmi le groupe consistant en l'arabinose, le galactose, le xylitol, le sorbitol, le mannitol, le mannose, le lactose, le maltol, le maltose, l'inositol, le xylose, le tréhalose, le sucrose, le fructose, le polydextrose, le thréose, l'érythrose, le ribose, le ribulose, le xylulose, le tagatose, l'allose, l'altrose, le gulose, l'idose, le talose, le sorbose, le psicose, le thréitol, l'érythitol, l'adonitol, l'arabitol, le talltol, l'iditol et le dulcitol.

3. Utilisation de la composition selon la revendication 1 ou 2, dans laquelle la quantité du composé alcalin est de 1 à 40% en poids et la quantité du composé d'hydroxylamine est de 0,1 à 50 % en poids.

4. Utilisation de la composition selon la revendication 1 ou 2, dans laquelle le composé alcalin est l'hydroxyde de tétraméthylammonium.

5. Utilisation de la composition selon la revendication 1 ou 2, dans laquelle le composé alcalin est l'hydroxyde de potassium et la composition comprend en outre l'ammoniaque.

6. Utilisation de la composition selon la revendication 5, dans laquelle la quantité de l'hydroxyde de potassium associée avec l'ammoniaque est de 0,1 à 65 % en poids et la quantité du composé d'hydroxylamine est de 0,1 à 50 % en poids.

7. Utilisation de la composition selon la revendication 1, dans laquelle la composition comprend un espèce sélectionné parmi le groupe consistant en un alcool sélectionné parmi le groupe consistant en le méthanol, l'éthanol, l'alcool d'isopropyle, l'alcool de n-propyle, l'isobutanol, et l'alcool de n-butyl, le pyrocatéchol, le butylcatéchol, le glycérine et un dérivé de glycérine quelconque.
